# FASCICULE DE BREVET EUROPEEN

(11) **EP 3 339 673 B1**
(45) Date de publication et mention de la délivrance du brevet: **14.02.2024**
(21) Numéro de dépôt: 17195455.5
(22) Date de dépôt: 09.10.2017
(51) Int. Cl.: F16F 1/12

(54) **DISPOSITIF DE GUIDAGE D'UN RESSORT DANS UN MECANISME DE COMMANDE ET APPAREIL DE PROTECTION ELECTRIQUE LE COMPORTANT**
FÜHRUNGSVORRICHTUNG EINER FEDER IN EINEM STEUERMECHANISMUS, UND ELEKTRISCHES SCHUTZGERÄT, DAS DIESE UMFASST
DEVICE FOR GUIDING A SPRING IN A CONTROL MECHANISM AND ELECTRICAL PROTECTION APPARATUS COMPRISING SAME

(30) Priorité: 22.12.2016 FR 1663097
(43) Date de publication de la demande: 27.06.2018
(73) Titulaire: Schneider Electric Industries SAS, 92500 Rueil-Malmaison (FR)
(72) Inventeur: BERARDENGO, Florent, 38050 GRENOBLE (FR); TREFFOT, Dominique, 38050 GRENOBLE (FR)
(74) Mandataire: Schneider Electric

(56) Documents cités:
- EP-A1- 2 602 804
- DE-A1- 19 504 961
- DE-U1- 9 416 903
- FR-A1- 2 832 473
- US-A1- 2015 102 246

## Description

### DOMAINE TECHNIQUE

La présente invention concerne un dispositif de guidage d'un ressort appartenant à un mécanisme de commande, ce dispositif comportant deux éléments aptes à coulisser l'un par rapport à l'autre et étant reliés de manière articulée respectivement à deux axes dont l'un au moins est relié mécaniquement à un arbre de manoeuvre, et un ressort de compression monté autour de ces deux éléments et en appui par ses deux extrémités opposées respectivement sur les deux axes précités par l'intermédiaire respectivement de deux embases, chacune de ses embases étant montée articulée par rapport à l'un des axes précités.

### ETAT DE LA TECHNIQUE ANTERIEURE

On connaît des dispositifs de guidage utilisés pour le guidage de ressorts de compression dont la fonction est, soit de procurer une aide additionnelle destinée à ajouter de la puissance et de la rapidité à la manoeuvre par un utilisateur, d'un arbre de sortie du mécanisme, soit à actionner un dispositif de manoeuvre à la place d'un utilisateur par un armement du ressort par compression de ce dernier suivi d'une décompression brusque de ce ressort produisant l'actionnement du dispositif de sortie/entraînement.

Ainsi, un tel sous-ensemble peut être monté soit entre deux axes appartenant respectivement à deux manivelles de manoeuvre de deux arbres, soit entre un axe de manivelle de manoeuvre et un axe fixe.

On connaît également un dispositif de guidage d'un ressort appartenant à un mécanisme de commande, ce dispositif comportant deux bielles aptes à coulisser l'une par rapport à l'autre et reliées de manière articulée respectivement par leurs extrémités libres à deux axes dont l'un au moins est relié mécaniquement à un arbre dit de manoeuvre, et un ressort de compression en appui par ses deux extrémités opposées respectivement sur les deux axes précités. Ce dispositif comporte des moyens de guidage en coulissement des deux bielles l'une par rapport à l'autre, ces moyens de guidage comportant des orifices et des rivets, un orifice oblong fermé formé à l'une des extrémités de chacune des bielles, un orifice oblong ouvert formé à l'autre extrémité de chacune des bielles, lesdites bielles étant montées tête bêche, les orifices oblongs fermés étant aptes à retenir prisonniers respectivement les deux axes, les deux orifices oblongs ouverts étant aptes à laisser échapper respectivement les deux axes, de manière à faire varier la course de guidage lors des phases de compression et de décompression du ressort.

Or, on peut observer dans ce dispositif une mauvaise qualité de guidage du ressort pendant les phases d'ouverture et de fermeture pouvant produire un phénomène de matage du ressort sur les bielles, ce qui peut entraîner une dégradation des rivets, et une fissuration de l'embase de guidage.

On connaît également les documents DE 94 16 903 et DE 195 04 961 décrivant un dispositif selon le préambule de la revendication 1.

La présente invention résout ces problèmes et propose un dispositif de guidage d'un ressort dans un mécanisme de commande, permettant d'obtenir un alignement correct de la force du ressort par rapport à la trajectoire de ce ressort, ceci permettant de limiter les risques de déformation du ressort et donc de pouvoir utiliser des pièces présentant un coût moins élevé. La présente invention a encore pour objet un appareil de protection électrique comportant un tel dispositif de guidage.

### EXPOSE DE L'INVENTION

A cet effet, la présente invention a pour objet un dispositif de guidage d'un ressort appartenant à un mécanisme de commande du genre précédemment mentionné, ce dispositif comportant deux éléments aptes à coulisser l'un par rapport à l'autre et étant reliés de manière articulée respectivement à deux axes dont l'un au moins est relié mécaniquement à un arbre de manoeuvre, et un ressort de compression monté autour des deux parties et en appui par ses deux extrémités opposées respectivement sur les deux axes précités par l'intermédiaire respectivement de deux embases, ce dispositif comportant deux tiges, chaque tige étant fixée par l'une de ses extrémités sur l'une des embases précitées, et étant montée coulissante par son extrémité opposée, par rapport à l'autre des embases précitées, caractérisé en ce que les deux tiges respectivement première et seconde sont fixées par l'une de leurs extrémités respectivement aux deux embases respectivement première et seconde, et chaque première et seconde embase comporte une partie formant fourreau apte à recevoir à coulissement l'extrémité libre de, respectivement, la seconde et la première tige, de telle manière que lorsque ces extrémités libres sont montées dans les fourreaux correspondants, lesdites tiges s'étendent sensiblement parallèlement l'une par rapport à l'autre, en ce que les deux parties formant fourreau précitées constituent par leur surface extérieure un moyen de guidage du ressort, et les deux parties formant fourreau précitées s'étendent sur une longueur correspondant sensiblement à la moitié de la longueur des tiges.

La présente invention a encore pour objet un appareil de protection électrique comportant un dispositif de guidage de ressort comportant les caractéristiques précédemment mentionnées.

Selon une caractéristique particulière, cet appareil est un interrupteur-sectionneur moyenne tension.

Mais d'autres avantages et caractéristiques de l'invention apparaîtront mieux dans la description détaillée qui suit et se réfère aux dessins annexés donnés uniquement à titre d'exemple et dans lesquels :
- Les figures 1 à 6 illustrent une première réalisation d'un dispositif de guidage qui n'est pas selon l'invention,
- La figure 1 est une vue en perspective du dispositif de guidage selon cette première réalisation,
- La figure 2 est une vue en coupe longitudinale du même dispositif de guidage, selon un plan passant par les axes des deux tiges,
- Les figures 3 et 4 sont deux vues en perspective illustrant le montage du dispositif,
- Les figures 5 et 6 sont deux vues en perspective illustrant le dispositif de guidage respectivement dans une position comprimée et dans une position décomprimée du ressort,
- Les figures 7 à 9 illustrent une seconde réalisation du dispositif de guidage selon l'invention,

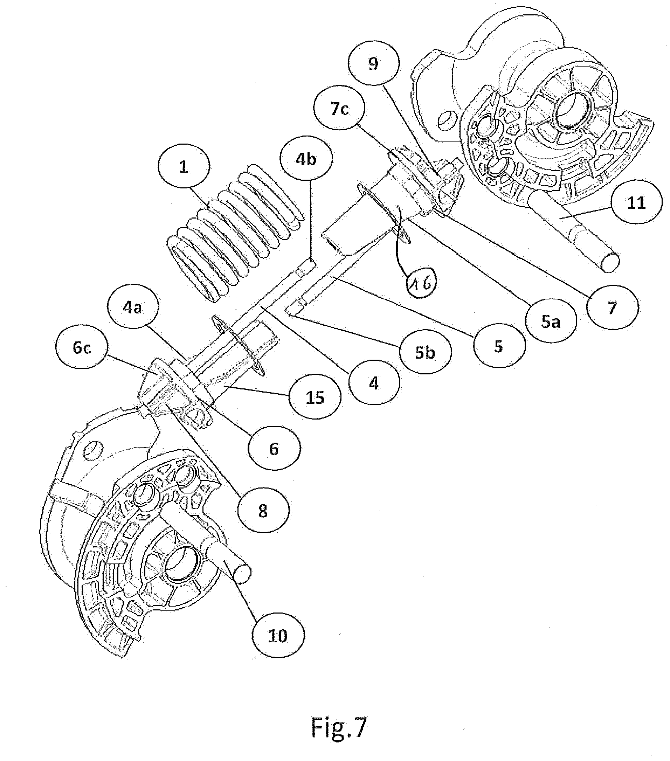

- La figure 7 est une vue en perspective illustrant les différents éléments constituants du dispositif,

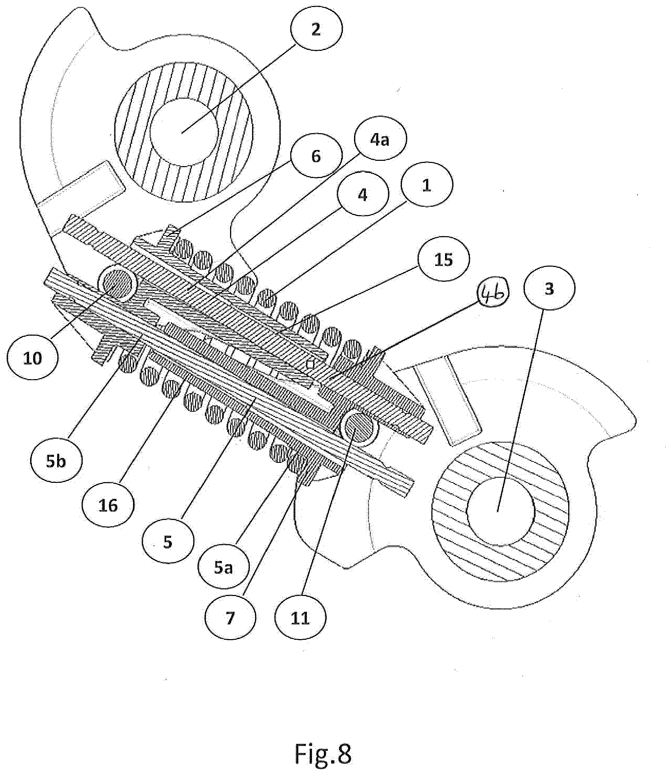

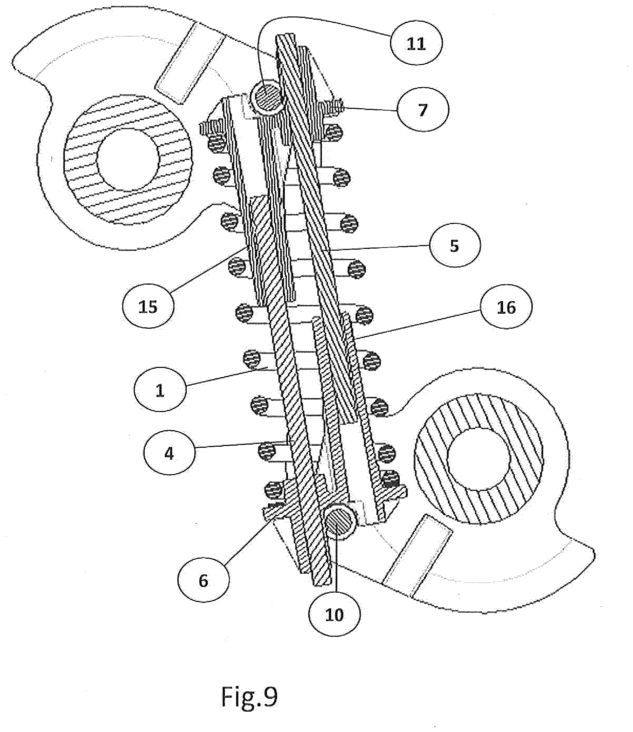

- Les figures 8 et 9 sont des vues en coupe selon un plan passant par les deux axes des deux tiges, du dispositif de guidage selon l'invention, respectivement en position comprimée et en position décomprimée du ressort.

Sur les figures, on voit un dispositif D de guidage d'un ressort selon l'invention, ledit ressort 1 appartenant par exemple à un mécanisme dit à tumbler, ce mécanisme faisant partie du dispositif de commande d'un appareil de protection électrique tel un disjoncteur.

De manière connue en soi, un tel dispositif est destiné à être placé entre deux arbres 2,3 respectivement par exemple un arbre de manoeuvre destiné à être actionné par un utilisateur et un arbre d'entraînement des contacts mobiles de l'appareil (ces contacts n'étant pas représentés).

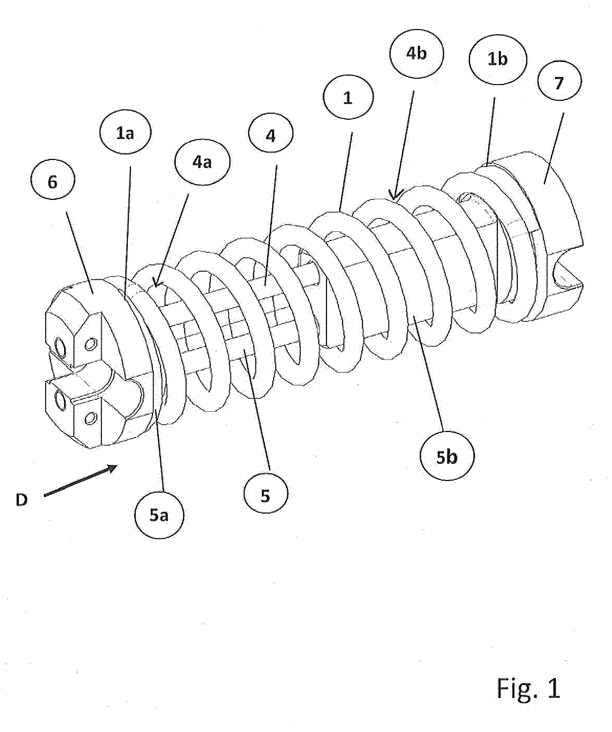

Selon la réalisation du dispositif illustrée sur les figures 1 à 6, ce dispositif de guidage D comporte un ensemble comportant deux tiges 4,5 fixées respectivement par l'une de leurs extrémités 4a,5a à une première embase 6 et montées coulissantes par leur extrémité opposée 4b,5b à l'intérieur d'une embase dite seconde 7, et un ressort dit de compression 1 monté autour des deux tiges et en appui par ses deux extrémités opposées 1a,1b sur les deux embases 6,7. Ces deux embases comportent chacune un évidement 8,9 de forme sensiblement cylindrique destiné à recevoir un axe 10,11 solidaire de l'un des arbres précités 2,3. Cet ensemble est destiné à être placé entre les deux axes précités 10,11 de la manière qui sera décrite dans ce qui suit.

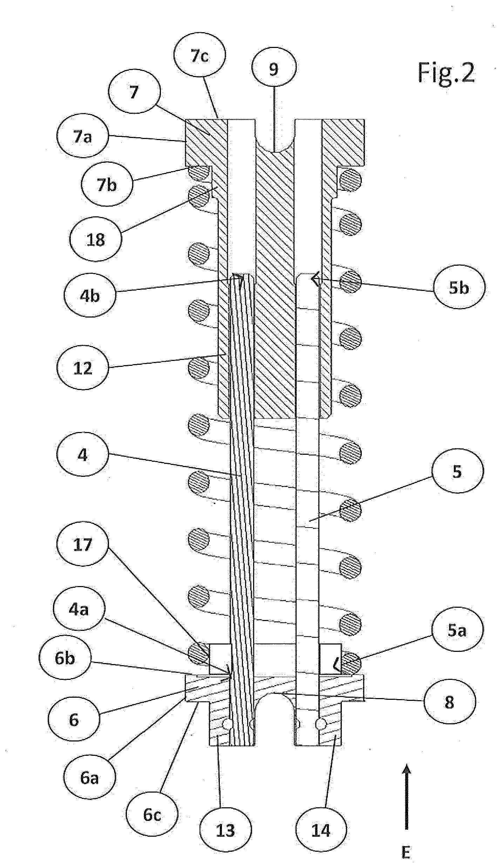

Tel que plus particulièrement illustré sur les figures 1 et 2, les deux embases 6,7 comportent chacune une portion de forme sensiblement cylindrique 6a,7a formant par l'une de ses faces planes, une surface d'appui 6b,7b pour le ressort 1. La surface d'appui 7b de la seconde embase 7 comporte un élément en saillie 12 de forme sensiblement cylindrique constituant une portion de guidage du ressort lorsque ce dernier est monté autour de cette portion. Ces deux embases comportent sur leur face plane 6c,7c opposée à la précédente, l'évidement de forme partiellement cylindrique précité 8,9, cet évidement étant apte à recevoir un des axes précités. La première embase 6 comporte en outre deux éléments 13,14 s'étendant à partir de cette même surface vers l'extérieur dudit ensemble E selon une direction sensiblement perpendiculaire au plan de ladite surface, ces deux éléments dits éléments de guidage des axes étant destinés à faciliter la mise en place des axes 10,11 dans les évidements précités lors de la mise en place de l'ensemble E de guidage dans le mécanisme. On notera également que les deux embases 6,7 présentent sur leur surface d'appui 6b,7b du ressort 1, respectivement deux portions cylindriques 17,18 présentant un diamètre légèrement supérieur au diamètre de la portion de guidage 12, et destinées à recevoir respectivement les deux parties d'extrémités 1a,1b du ressort 1.

Tel que plus particulièrement illustré sur les figures 1 et 2, on voit que la portion de guidage 12 enserre les deux tiges 4,5 tout en permettant le coulissement des tiges à l'intérieur de ladite portion.

La portion de guidage 12 appartenant à la seconde embase 7 s'étend sur une longueur correspondant sensiblement à la moitié de la longueur des tiges 4,5.

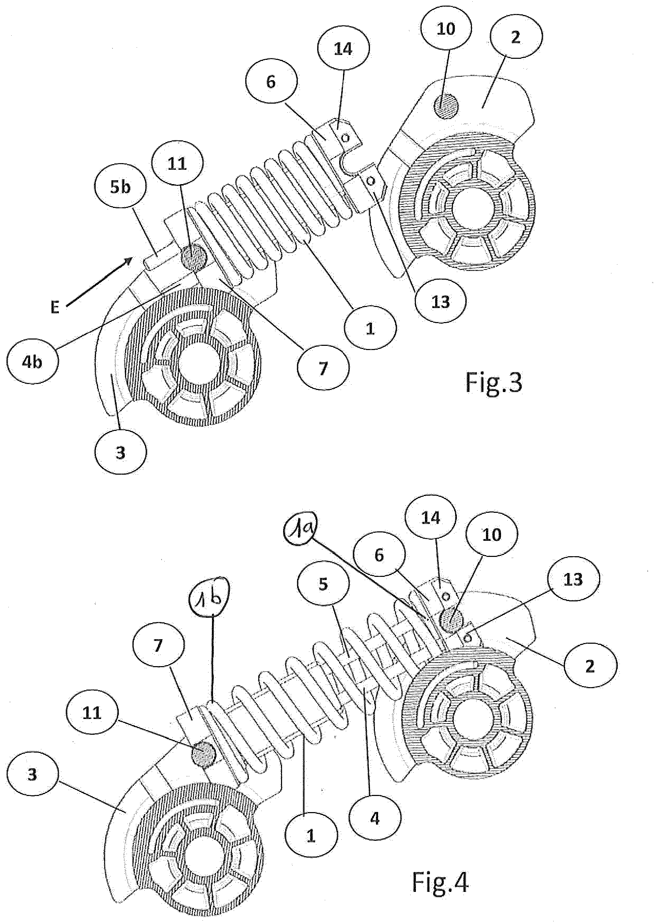

Les figures 3 et 4 illustrent le montage de l'ensemble de guidage entre les deux axes.

Sur la figure 3, le ressort 1 a été comprimé par rapprochement des embases 6,7 l'une par rapport à l'autre, et l'ensemble E est positionné entre les deux axes 10,11 de telle manière que la décompression du ressort 1 permette l'introduction de l'un 10 des axes dit premier, entre les éléments de guidage 13,14, et de l'autre axe 11, dit second, entre les parties d'extrémité 4b,5b des deux tiges 4,5, ces dernières ayant été découvertes lors de la compression du ressort 1 et étant aptes à être amenées de part et d'autre de l'axe dit second 11, cette position étant représentée sur la figure 4. Sur cette dernière figure, les deux extrémités 1a,1b du ressort 1 sont en appui respectivement sur les deux embases 6,7, et les deux embases sont en appui respectivement sur les deux axes 10,11.

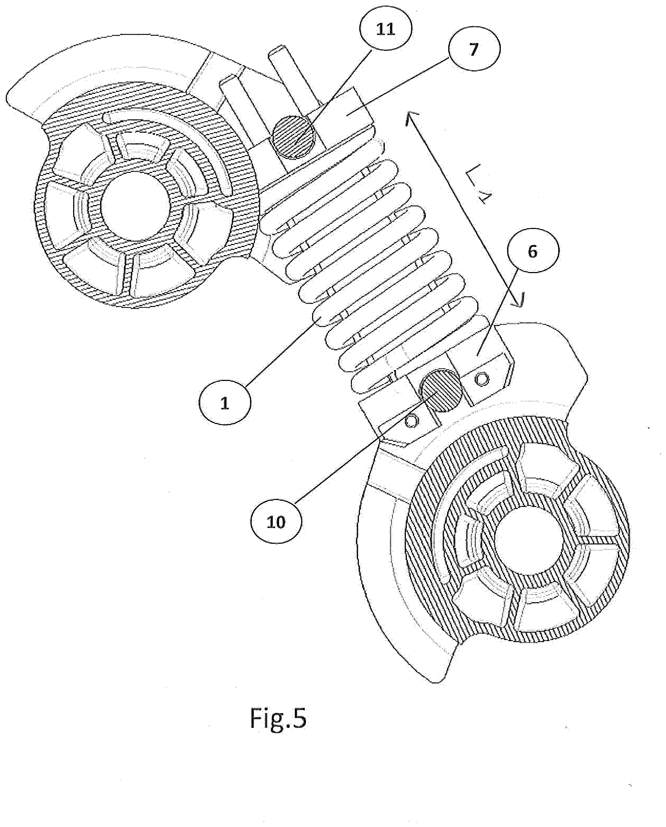

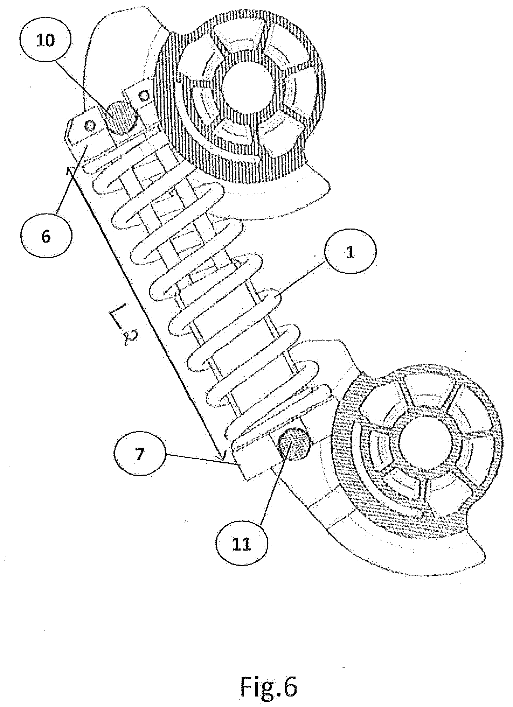

Sur les figures 5 et 6, on voit que la distance L2 entre les deux embases 6,7 en position décomprimée du ressort 1 correspond sensiblement au double de la distance L1 entre les deux embases 6,7 en position comprimée du ressort 1.

Selon la réalisation décrite sur les figures 7 à 9, les deux tiges 4,5 sont fixées par l'une 4a,5a de leurs extrémités respectivement à deux embases différentes 6,7, et chaque embase 6,7 comporte un élément de guidage formant fourreau 15,16 s'étendant en direction de l'autre embase, ledit élément de guidage étant destiné à recevoir à coulissement l'extrémité libre 4b,5b de la tige 4,5 fixée à l'autre 7,6 des deux embases 6,7.

Ces deux éléments de guidage dits fourreaux 15,16 permettent également de guider le déplacement du ressort 1 monté à la fois autour des deux tiges 4,5, et de ces éléments de guidage formant fourreau 15,16. De la même manière que dans la réalisation précédente, la surface extérieure 6c,7c des embases 6,7 présente un évidement 8,9 destiné à recevoir l'un des axes 10,11. La mise en place de cet ensemble E est réalisée de la même manière que précédemment décrit pour la réalisation précédente et ne sera donc pas décrite davantage.

Dans les positions comprimée et décomprimée illustrées respectivement sur la figure 8 et la figure 9, le ressort 1 est en appui par ses deux extrémités opposées 1a,1b respectivement sur les deux embases précitées 6,7, lesquelles embases sont en appui respectivement sur les deux axes précités 10,11.

On a donc réalisé grâce à l'invention un dispositif de guidage d'un ressort permettant d'obtenir un alignement correct de la force du ressort par rapport à la trajectoire de son déplacement. Cette solution permet d'avoir une longueur de guidage du ressort minimale sensiblement égale à six fois le diamètre de chaque tige de guidage.

Cette qualité d'alignement permet de supprimer les effets de déformation et de battements du ressort à la fin des manoeuvres d'ouverture et de fermeture, et réduit les contraintes sur chacune des parties du dispositif de guidage. Il permet également de réduire les effets de bras de levier du mécanisme.

Ce dispositif de guidage du ressort peut être installé ou démonté aisément sans qu'il soit nécessaire de démonter le mécanisme.

Les petits diamètres des tiges de guidage permettent de réduire l'encombrement du système.

On observe qu'après 20000 opérations, il n'y a aucune trace visible d'usure, de fentes ou de fissures sur les parties testées.

Bien entendu, l'invention n'est pas limitée aux modes de réalisation décrits et illustrés qui n'ont été donnés qu'à titre d'exemple.

## Revendications

1. Dispositif de guidage d'un ressort appartenant à un mécanisme de commande, ce dispositif comportant deux éléments aptes à coulisser l'un par rapport à l'autre et étant reliés de manière articulée respectivement à deux axes dont l'un au moins est relié mécaniquement à un arbre de manoeuvre, et un ressort de compression monté autour de ces deux éléments et en appui par ses deux extrémités opposées respectivement sur les deux axes précités par l'intermédiaire respectivement de deux embases, chacune de ses embases étant montée articulée par rapport à l'un des axes précités, ce dispositif comportant deux tiges (4,5), chaque tige étant fixée par l'une (4a,5a) de ses extrémités sur l'une des embases précitées (6,7), et étant montée coulissante par son extrémité opposée (4b,5b), par rapport à l'autre des embases précitées (7,6), les deux tiges (4,5) respectivement première et seconde sont fixées par l'une de leurs extrémités (4a,5a) respectivement aux deux embases respectivement première (6) et seconde (7), **caractérisé en ce que** chaque première et seconde embase (6,7) comporte une partie formant fourreau (15,16) apte à recevoir à coulissement l'extrémité libre (5b,4b) de, respectivement, la seconde (5) et la première tige (4), de telle manière que lorsque ces extrémités libres (5b,4b) sont montées dans les fourreaux correspondants (15,16), lesdites tiges (4,5) s'étendent sensiblement parallèlement l'une par rapport à l'autre, les deux parties formant fourreau précitées (15,16) constituant par leur surface extérieure un moyen de guidage du ressort et les deux parties formant fourreau précitées (15,16) s'étendant sur une longueur correspondant sensiblement à la moitié de la longueur des tiges.

2. Appareil de protection électrique comportant un dispositif D de guidage de ressort selon la revendication 1.

3. Appareil de protection électrique selon la revendication 2, **caractérisé en ce que** cet appareil est un interrupteur-sectionneur moyenne tension.

## Patentansprüche

1. Führungsvorrichtung einer Feder, die zu einem Steuermechanismus gehört, wobei diese Vorrichtung zwei Elemente, die geeignet sind, im Verhältnis zueinander zu gleiten und gelenkig jeweils mit zwei Achsen verbunden sind, von denen wenigstens eine mit einer Betätigungswelle mechanisch verbunden ist, und eine Druckfeder aufweist, die um diese zwei Elemente herum und durch ihre zwei gegenüberliegenden Enden jeweils in Anlage an die zwei vorgenannten Achsen mittels jeweils zweier Sockel montiert ist, wobei jeder ihrer Sockel gelenkig im Verhältnis zu einer der vorgenannten Achsen montiert ist, wobei diese Vorrichtung zwei Stifte (4, 5) aufweist, wobei jeder Stift durch eines (4a, 5a) seiner Enden auf dem einen der vorgenannten Sockel (6, 7) befestigt ist und durch sein gegenüberliegendes Ende (4b, 5b) im Verhältnis zum anderen der vorgenannten Sockel (7, 6) gleitend gelagert ist, wobei die zwei Stifte (4, 5), der erste bzw. der zweite, durch eins ihrer Enden (4a, 5a) jeweils an den zwei Sockeln, dem ersten (6) bzw. zweiten (7), befestigt sind, **dadurch gekennzeichnet, dass** jeder erste und zweite Sockel (6, 7) einen Abschnitt aufweist, der eine Hülse (15, 16) bildet, die geeignet ist, das freie Ende (5b, 4b) des zweiten (5) bzw. ersten (4) Stifts so aufzunehmen, dass, wenn diese freien Enden (5b, 4b) in den entsprechenden Hülsen (15, 16) montiert sind, die Stifte (4, 5) sich im Wesentlichen parallel zueinander erstrecken, wobei die zwei vorgenannten Abschnitte, die eine Hülse (15, 16) bilden, durch ihre Außenseite ein Führungsmittel der Feder bilden und sich die zwei vorgenannten Abschnitte, die die Hülse (15, 16) bilden, über eine Länge erstrecken, die im Wesentlichen der Hälfte der Länge der Stifte entspricht.

2. Elektrische Schutzeinrichtung, die eine Führungsvorrichtung D einer Feder nach Anspruch 1 aufweist.

3. Elektrische Schutzeinrichtung nach Anspruch 2, **dadurch gekennzeichnet, dass** diese Einrichtung ein **Mittelspannungs-Lasttrennschalter** ist.

## Claims

1. Device for guiding a spring which is part of a control mechanism, this device comprising two elements which are able to slide in relation to one another and are respectively articulated to two pins, at least one of which is mechanically connected to an operating shaft, and a compression spring which is mounted around these two elements and bears by way of its two opposite ends respectively against the two aforementioned pins via respectively two bases, each of its bases being mounted articulated in relation to one of the aforementioned pins, this device comprising two rods (4, 5), each rod being fixed by way of one (4a, 5a) of its ends to one of the aforementioned bases (6, 7) and being mounted slidingly by way of its opposite end (4b, 5b) in relation to the other one of the aforementioned bases (7, 6), the two rods (4, 5), respectively first and second rod, are fixed by way of one of their ends (4a, 5a) respectively to the two bases, respectively first base (6) and second base (7), **characterized in that** each first and second base (6, 7) has a sleeve-forming portion (15, 16) that is able to slidingly receive the free end (5b, 4b) of, respectively, the second rod (5) and the first rod (4) such that, when these free ends (5b, 4b) are mounted in the corresponding sleeves (15, 16), said rods (4, 5) extend substantially parallel to one another, the two aforementioned sleeve-forming portions (15, 16) making up, by way of their outer surface, a means for guiding the spring and the two aforementioned sleeve-forming portions (15, 16) extending over a length corresponding substantially to half of the length of the rods.

2. Electrical protection apparatus comprising a spring guiding device D according to Claim 1.

3. Electrical protection apparatus according to Claim 2, **characterized in that** this apparatus is a medium-voltage switch-disconnector.
